# EUROPEAN PATENT SPECIFICATION

(11) **EP 2 938 176 B1**
(45) Date of publication and mention of the grant of the patent: **14.02.2018**
(21) Application number: 12890262.4
(22) Date of filing: 20.12.2012
(51) Int. Cl.: H05K 13/02, H01L 21/68

(54) **DIE SUPPLY DEVICE**
CHIPZUFUHRVORRICHTUNG
DISPOSITIF D'ALIMENTATION DE PUCES

(43) Date of publication of application: 28.10.2015
(73) Proprietor: Fuji Machine Mfg. Co., Ltd., Chiryu-shi Aichi 472-8686 (JP)
(72) Inventor: TSUGE, Kuniaki, Chiryu-shi Aichi 472-8686 (JP); KIJIMA, Tatsuya, Nagoya-shi Aichi 460-0008 (JP); YAMASHITA, Yoshinori, Nagoya-shi Aichi 460-0008 (JP)
(74) Representative: Grünecker Patent- und Rechtsanwälte PartG mbB
(86) International application number: PCT/JP2012/083157
(87) International publication number: WO 2014/097463

(56) References cited:
- WO-A1-2011/128982
- JP-A- H1 167 876
- JP-A- 2002 026 041
- JP-A- 2006 080 105
- JP-A- 2012 222 054
- JP-B2- 4 919 241
- US-A- 6 149 047
- US-B1- 6 311 391

## Description

### Technical Field

The present invention relates to a die supply apparatus which supplies a die from a wafer expander in which an elastic dicing sheet attached with a diced wafer is expanded.

### Background Art

Recently, PTL 1 (JP-A-2010-129949) discloses that a die supply apparatus supplying dies is set to a component mounting machine and dies are mounted in a circuit board by the component mounting machine. The die supply apparatus includes a wafer pallet in which an elastic dicing sheet attached with a wafer which is diced so as to be divided into a plurality of dies is expanded in a dicing frame and a push-up pin which is disposed below the dicing sheet. When a suction nozzle is lowered and a die on the dicing sheet is adsorbed so as to be picked up, an attachment portion of the target adsorption die on the dicing sheet is pushed up with the push-up pin, and while the attachment portion of the die is partially peeled off from the dicing sheet, the suction nozzle is caused to adsorb the die so as to pick up the die from the dicing sheet.

In this case, since the dicing sheet is evenly stretched (expanded) in XY-directions and gaps are provided between the dies so as to allow the die to be easily picked up, the position of each die on the dicing sheet varies depending on a stretching amount of the dicing sheet. Therefore, the die supply apparatus houses a camera for recognizing the position of the die in images. Before the die on the dicing sheet is adsorbed, a target adsorption die is imaged from above by a camera, and the position of the die is recognized, thereby executing push-up operation and adsorption operation of the die. Then, a position of a die to be adsorbed next (hereinafter, referred to as "the next adsorption die") is estimated based on the recognition position of the die which is subjected to the present adsorption operation. The estimated position for the next adsorption die is adopted as the target imaging position of the die. The next adsorption die is imaged by the camera, and the position for the next adsorption die is recognized, thereby repeating a process in which the above-described push-up operation and adsorption operation are executed. Thus, the dies on the dicing sheet are adsorbed in predetermined order.

Generally, since one wafer includes a defective die, quality inspection is performed for every die through a die inspection step. A defective die is labeled with a bad mark in ink. In a die mounting step, each die is imaged by the camera, and the presence/absence of the bad mark is recognized in images. Only the non-defective die (the non-defective chip) is picked up from the wafer in order, thereby being mounted in a board.

However, in such a method, each die needs to be imaged by the camera so as to recognize the presence/absence of the bad mark in images, thereby leading to a disadvantage such as poor productivity.

Recently, PTL 2 (JP-A-2001-250834) discloses a mainstream method in which wafer map data indicating the quality of the die at each position in the diced wafer is made during the die inspection step, and only the non-defective die (the non-defective chip) is picked up from the wafer in order during the die mounting step by using the wafer map data, thereby being mounted in the board. PTL 3 (US 6311391 B1) discloses a die supply system including a flip-chip bonding apparatus with a die inverting device. Said system working on die position optical recognition principle.

### Citation List

### Patent Literature

PTL 1: JP-A-2010-129949
PTL 2: JP-A-2001-250834
PTL 3: US 6311391 B1

### Summary of Invention

### Technical Problem

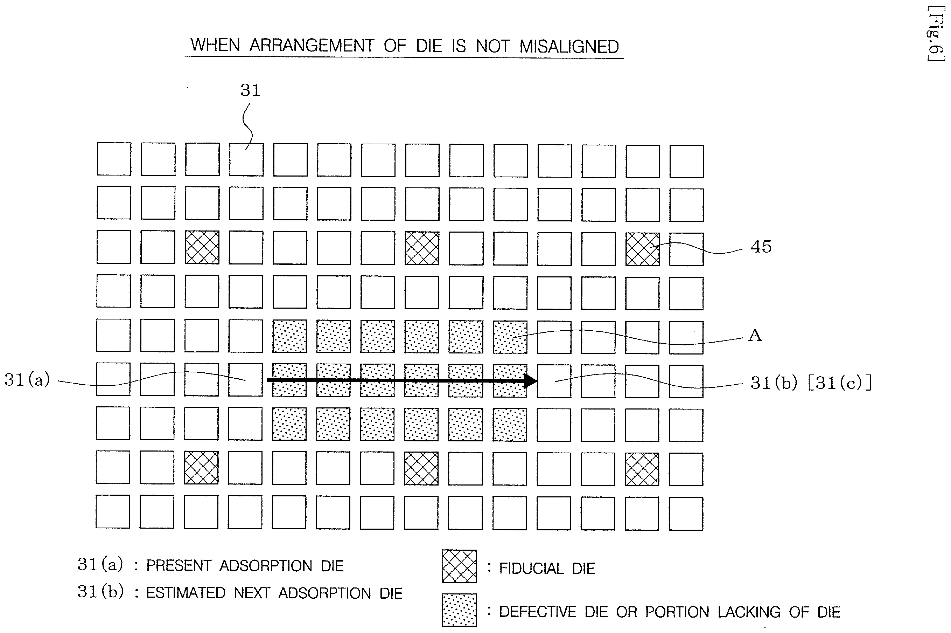

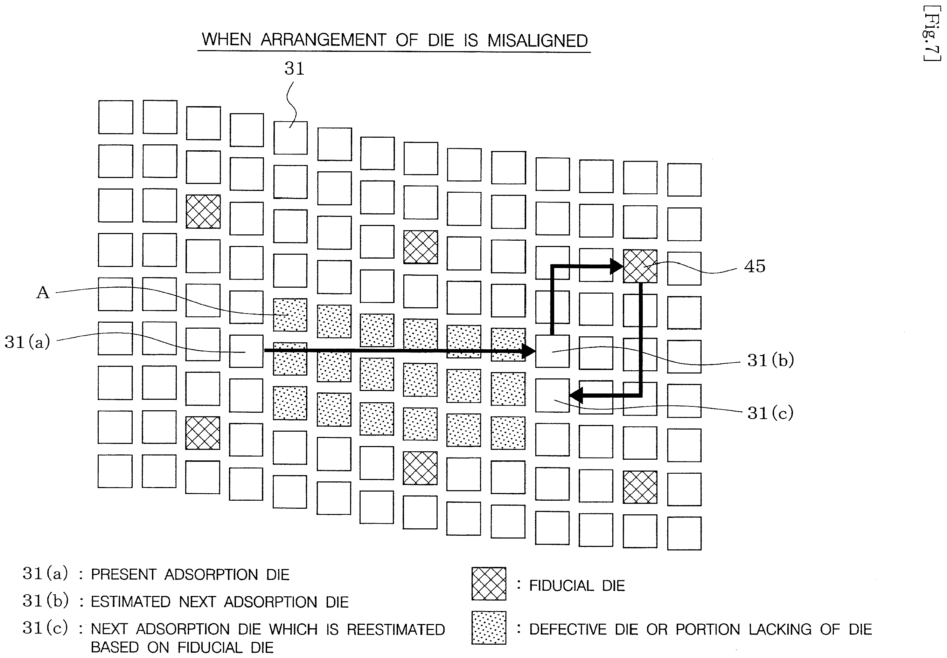

Incidentally, since a dicing sheet attached with a diced wafer is expanded and mounted in a dicing frame, an arrangement of the die may be in a misaligned state due to the unevenly expanded dicing sheet. For example, as illustrated in Figs. 6 and 7, if defective dies A or areas lacking die 31 continuously occur in the arrangement of the die 31, an interval from a position of a die 31(a) which is subjected to a present adsorption operation to a position of a non-defective die 31(b) to be adsorbed next is lengthened, thereby increasing the influence of misalignment in the arrangement of the die 31. Therefore, as illustrated in Fig. 7, when the arrangement of the die 31 is misaligned, if the interval with respect to the position for the next adsorption die 31(b) which is estimated based on a recognition position of the die 31(a) which is subjected to the present adsorption operation is lengthened, the estimated next adsorption die 31(b) may be a die at a position misaligned from the proper position for a next adsorption die 31(c), and thus, a mismatch may occur in a correspondence relationship between the quality of the die 31 at each position in an actual wafer and wafer map data. As a result, the non-defective die 31 may not be adsorbed in proper adsorption order, or the defective die A or the area lacking the die may be mistakenly estimated and imaged for the next adsorption die, thereby leading to problems.

An object of the present invention is to provide a die supply apparatus in which even though the arrangement of the die is in a misaligned state due to the unevenly expanded dicing sheet, a non-defective die can be adsorbed in proper adsorption order, and a disadvantage of mistakenly estimating and imaging a defective die or an area lacking a die for a next adsorption die can be solved.

### Solution to Problem

In order to solve the problem, according to the present invention, a die supply apparatus includes a wafer expander in which an elastic dicing sheet attached with a wafer that is diced so as to be divided into a plurality of dies is expanded and a push-up mechanism in which a push-up pin that is disposed below the dicing sheet moves vertically; and pushing up an attachment portion of the target adsorption die on the dicing sheet with the push-up pin, causing the suction nozzle to adsorb the die, and picking a die up from the dicing sheet, when a suction nozzle is lowered and a die on the dicing sheet is adsorbed so as to be picked up. The die supply apparatus includes adsorption order decision means for deciding the adsorption order of the dies on the dicing sheet, a camera that images the dies on the dicing sheet, image processing means for recognizing a position of the die by processing an image of the die which is imaged by the camera, next adsorption die position estimation means for estimating a position of a die to be adsorbed next (hereinafter, referred to as "the next adsorption die") based on the recognition position of the die which is recognized by the image processing means, control means for executing push-up operation and adsorption operation of the die by causing the position for the next adsorption die which is estimated by the next adsorption die position estimation means to be a target imaging position of the die for every adsorption operation, imaging the next adsorption die by the camera, and recognizing the position for the next adsorption die by the image processing means, and a plurality of image-recognizable fiducial dies that are provided in a predetermined disposition in an arrangement of the dies on the dicing sheet. When an interval from a position of the die which is subjected to a present adsorption operation to a position for the next adsorption die estimated by the next adsorption die position estimation means is equal to or greater than a predetermined value, in addition to recognizing the position for the next adsorption die, the control means selects a fiducial die close to the next adsorption die from the plurality of fiducial dies, images the fiducial die by the camera, recognizes the position of the fiducial die, and determines whether or not the recognition position for the next adsorption die is the proper position for the next adsorption die based on a positional relationship between the recognition position of the fiducial die and the recognition position for the next adsorption die (a relative positional relationship between the former and the latter). When it is determined that the recognition position for the next adsorption die is the proper position for the next adsorption die, the control means executes push-up operation and adsorption operation based on the recognition position for the next adsorption die. When it is determined that the recognition position for the next adsorption die is not the proper position for the next adsorption die, the control means reestimates a position of the die to be adsorbed next based on the recognition position of the fiducial die, images the die by the camera, recognizes the position of the die, and executes push-up operation and adsorption operation.

In this case, when the interval from the position of the die which is subjected to the present adsorption operation to the position for the next adsorption die is equal to or greater than a predetermined value, a fiducial die close to the next adsorption die is imaged by a camera, and the position of the fiducial die is recognized. Then, based on a positional relationship between a recognition position of the fiducial die and a recognition position for the next adsorption die (a relative positional relationship between the former and the latter), it is determined whether or not the recognition position for the next adsorption die is a proper position for the next adsorption die. Therefore, when the next adsorption die estimated based on the position of the die which is subjected to the present adsorption operation is a die at a position misaligned from the proper position for the next adsorption die, the position of the die to be adsorbed next can be reestimated based on the position of the fiducial die close to the next adsorption die. Accordingly, even though an arrangement of the die is in a misaligned state due to the unevenly expanded dicing sheet, a non-defective die can be adsorbed in proper adsorption order, and thus, it is possible to solve the disadvantage of mistakenly estimating and imaging a defective die or an area lacking the die for the next adsorption die.

In this case, storage means for storing wafer map data indicating the quality of the die at each position on the dicing sheet and the position of the fiducial die may be included. With reference to the wafer map data, based on the recognition position of the die recognized by the image processing means, a position of a non-defective die to be adsorbed next may be revised, and the position for the next adsorption die may be estimated. When the interval from the position of the die which is subjected to the present adsorption operation to the estimated position for the next adsorption die is equal to or greater than a predetermined value, with reference to the wafer map data, a fiducial die close to the next adsorption die may be selected from the plurality of fiducial dies. In this manner, it is possible to easily execute the present invention by utilizing the wafer map data.

According to the present invention, the interval from the position of the die which is subjected to the present adsorption operation to the position for the next adsorption die estimated by the next adsorption die position estimation means may be judged by the number of die arrangement pitches (the number of the defective dies or the portions lacking the die occurring within the interval), or may be judged by distance (mm). If the interval is judged by the number of the die arrangement pitches, the interval does not need to be converted into distance (mm), and thus, the calculation can be simplified to the extent thereof.

### Brief Description of Drawings

[Fig. 1] Fig. 1 is a perspective view illustrating the appearance of a die supply apparatus in an exemplary embodiment of the present invention.
[Fig. 2] Fig. 2 is a perspective view illustrating the appearance of a push-up unit and the peripheral section thereof.
[Fig. 3] Fig. 3 is a perspective view illustrating the appearance of a wafer pallet.
[Fig. 4] Fig. 4 is a partially broken enlarged view illustrating a state where a push-up pot is raised to an adsorption position during a push-up operation.
[Fig. 5] Fig. 5 is a partially broken enlarged view illustrating a state where a push-up pin is caused to protrude from the push-up pot during a push-up operation.
[Fig. 6] Fig. 6 is a diagram of a die arrangement illustrating a positional relationship between a present adsorption die and a next adsorption die when the die arrangement is not misaligned.
[Fig. 7] Fig. 7 is another diagram of the die arrangement illustrating the positional relationship between the present adsorption die and the next adsorption die when the die arrangement is misaligned.
[Fig. 8] Fig. 8 is a flow chart illustrating a process flow of processing a die supply apparatus control program.

### Description of Embodiments

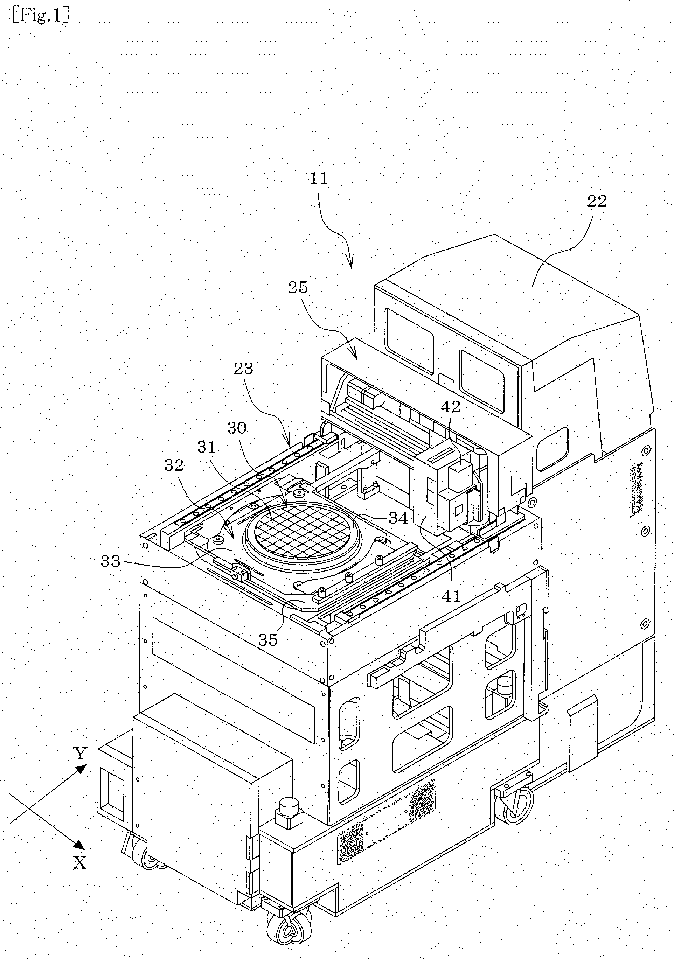

Hereinafter, descriptions will be given regarding an exemplary embodiment in which aspects for realizing the present invention are specified. Firstly, a configuration of a die supply apparatus 11 will be schematically described with reference to Fig. 1.

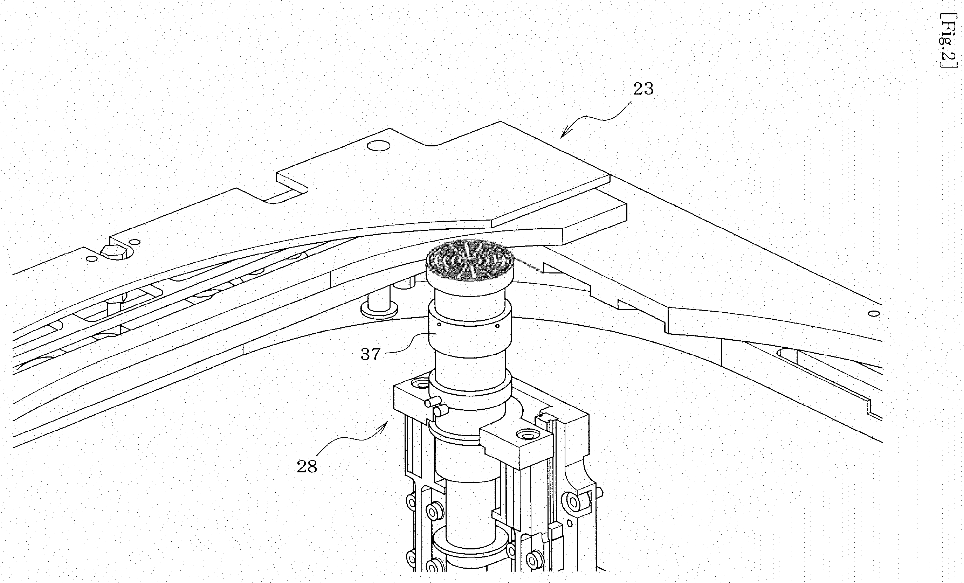

The die supply apparatus 11 includes a magazine holding section 22 (a tray tower), a pallet drawing-out table 23, an XY moving mechanism 25, a push-up unit 28 (refer to Fig. 2), and the like, and the pallet drawing-out table 23 is set in a state of being fitted in a component mounting machine (not illustrated).

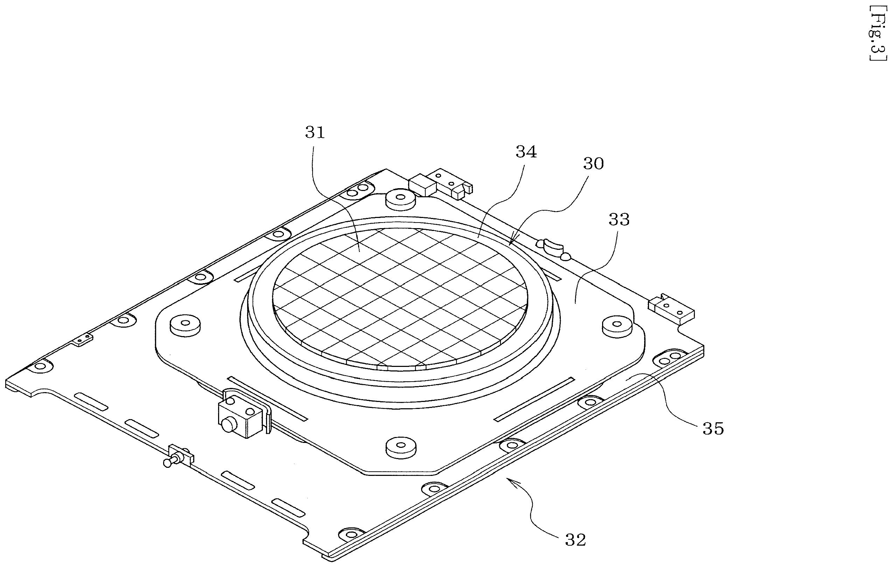

In a magazine (not illustrated) which is stored inside the magazine holding section 22 of the die supply apparatus 11 in a vertically movable manner, a wafer pallet 32 mounted with a wafer expander 30 is loaded in multiple stages, and the wafer pallet 32 is drawn out on the pallet drawing-out table 23 from the magazine during production. As illustrated in Fig. 3, in the wafer expander 30, an elastic dicing sheet 34 attached with a die 31 which is formed by dicing a wafer in a grid pattern is mounted on a dicing frame 33 having a circular opening portion in an expanded state, and the dicing frame 33 is installed in a pallet main body 35 by a screw clamp and the like.

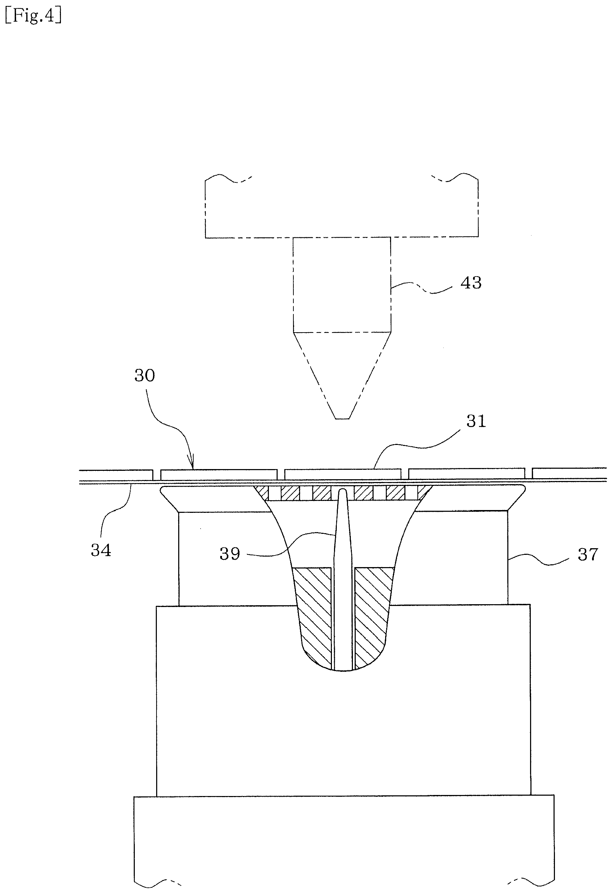

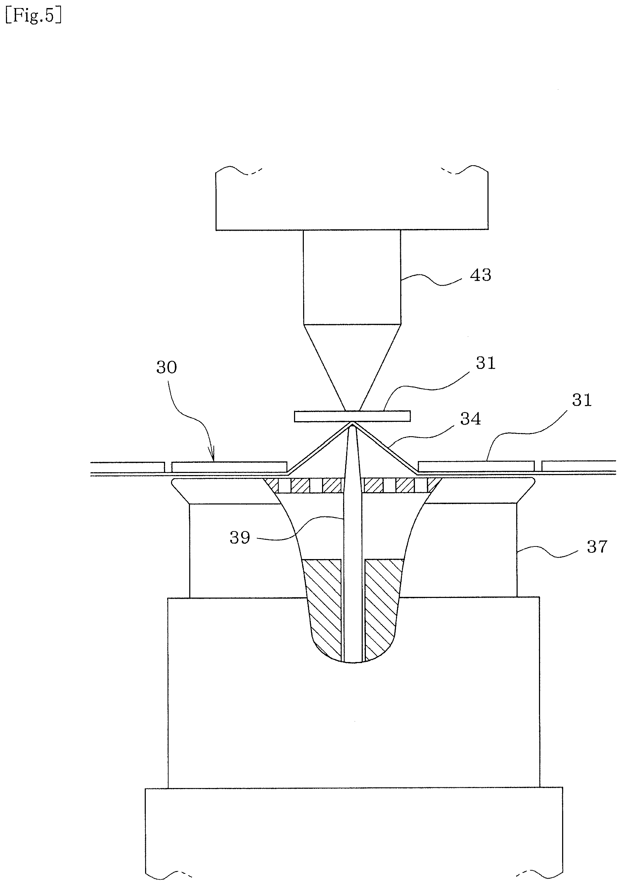

The push-up unit 28 (refer to Fig. 2) is configured to be movable in XY-directions in a spatial region below the dicing sheet 34 of the wafer pallet 32. Then, an attachment portion of the target pick-up (adsorption) die 31 on the dicing sheet 34 is locally pushed up from below by a push-up pin 39 of a push-up pot 37 (refer to Figs. 4 and 5) so that the attachment portion of the die 31 is partially peeled off from the dicing sheet 34, thereby causing the die 31 to rise so as to be easily picked up.

The push-up unit 28 adopts a servo motor (not illustrated) as a drive source, and is configured to vertically move in the entirety of the push-up unit 28. During the die pick-up operation, if the push-up unit 28 is raised so as to cause the top face of the push-up pot 37 to rise to a predetermined sheet adsorption position which substantially comes into contact with the dicing sheet 34 of the wafer pallet 32, the stopper mechanism (not illustrated) stops the push-up unit 28 from rising. If the raising operation is continued further, the push-up pin 39 (refer to Figs. 4 and 5) protrudes upward from the top face of the push-up pot 37, thereby pushing up the attachment portion of the target pick-up die 31 on the dicing sheet 34. In this case, a push-up height position (a push-up amount) of the push-up pin 39 can be adjusted by adjusting a rotation amount of the servo motor which is the drive source.

As illustrated in Fig. 1, the XY moving mechanism 25 is equipped with an adsorption head 41 and a camera 42, and the adsorption head 41 and the camera 42 integrally move in the XY-directions by the XY moving mechanism 25. The adsorption head 41 is provided with a suction nozzle 43 (refer to Figs. 4 and 5) which vertically moves and adsorbs the die 31 on the dicing sheet 34. The camera 42 images the die 31 on the dicing sheet 34 from above and performs image processing of the captured image, thereby allowing the suction nozzle 43 to recognize the position of the target adsorption die 31.

A control device (control means) of the die supply apparatus 11 also functions as image processing means. The target adsorption die 31 among the dies 31 on the dicing sheet 34 is imaged by the camera 42. The acquired image is processed, the position of the die 31 is recognized, and then, a push-up position and an adsorption position of the die 31 are decided. As illustrated in Fig. 5, the attachment portion of the target pick-up (adsorption) die 31 on the dicing sheet 34 is locally pushed up from below by the push-up pin 39 of the push-up pot 37 so that the attachment portion of the die 31 is partially peeled off from the dicing sheet 34. While causing the die 31 to rise so as to be easily picked up, the die 31 is adsorbed so as to be picked up by the suction nozzle 43. A position of the die 31 to be adsorbed next (hereinafter, refer to as "the next adsorption die") is estimated based on a recognition position of the die 31 which is subjected to a present adsorption operation. The estimated position for the next adsorption die 31 is adopted as a target imaging position of the die. The next adsorption die 31 is imaged by the camera 42, and the position for the next adsorption die 31 is recognized, thereby repeating a process in which the above-described push-up operation and adsorption operation are executed. Thus, the dies 31 on the dicing sheet 34 are adsorbed in a predetermined order.

Generally, one wafer includes a defective die. Therefore, based on a die inspection result, a wafer manufacturer makes wafer map data indicating the quality of the die 31 at each position in the diced wafer, and provides the wafer map data together with the wafer to a die mounting board manufacturer. The die mounting board manufacturer uses the die supply apparatus 11 so as to pick up only non-defective dies (non-defective chips) from the wafer in order according to the wafer map data, thereby mounting the non-defective dies on a board.

In this manner, when using the wafer map data, the quality of the die 31 at each position in the actual wafer needs to exactly correspond to the wafer map data.

However, since the dicing sheet 34 attached with the diced wafer is expanded so as to be mounted in the dicing frame 33, there is a case where arrangement of the die 31 is in a misaligned state due to the unevenly expanded dicing sheet 34. In this case, as illustrated in Figs. 6 and 7, if defective dies A or areas lacking die continuously occur in the arrangement of the die 31, an interval from the position of the die 31(a) which is subjected to the present adsorption operation to the position of the non-defective die 31(b) to be adsorbed next is lengthened, thereby increasing the influence of misalignment in the arrangement of the die 31. Therefore, as illustrated in Fig. 7, when the arrangement of the die 31 is misaligned, if the interval with respect to the position for the next adsorption die 31 (b) which is estimated based on a recognition position of the die 31(a) which is subjected to the present adsorption operation is lengthened, the estimated next adsorption die 31(b) may be a die at a position misaligned from the proper position for a next adsorption die 31(c), and thus, a mismatch may occur in a correspondence relationship between the quality of the die 31 at each position in an actual wafer and wafer map data. As a result, the non-defective die 31 may not be adsorbed in proper adsorption order, or the defective die A or the area lacking the die 31 may be mistakenly estimated and imaged for the next adsorption die.

As a countermeasure thereof, in the present exemplary example, as illustrated in Figs. 6 and 7, a plurality of image-recognizable fiducial dies 45 are disposed in the arrangement of the die 31 on the dicing sheet 34 at predetermined intervals. When the interval from the position of the die 31(a) which is subjected to the present adsorption operation to the estimated position for the next adsorption die 31(b) is equal to or greater than a predetermined value, in addition to recognizing the position for the next adsorption die 31(b), a fiducial die 45 close to the next adsorption die 31 (b) is selected from the plurality of fiducial dies 45. The fiducial die 45 is imaged by the camera 42. The position of the fiducial die 45 is recognized. Then, based on a positional relationship between the recognition position of the fiducial die 45 and the recognition position for the next adsorption die 31(b) (a relative positional relationship between the former and the latter), it is determined whether or not the recognition position for the next adsorption die 31(b) is the proper position for the next adsorption die 31(c). When it is determined that the recognition position for the next adsorption die 31(b) is the proper position for the next adsorption die 31(c), the push-up operation and adsorption operation are executed based on the recognition position for the next adsorption die 31(b). When it is determined that the recognition position for the next adsorption die 31(b) is not the proper position for the next adsorption die 31(c), the position of the die 31(c) to be adsorbed next is reestimated based on the recognition position of the fiducial die 45. Then, the die 31(c) is imaged by the camera 42 and the position of the die 31(c) is recognized, thereby executing the push-up operation and adsorption operation.

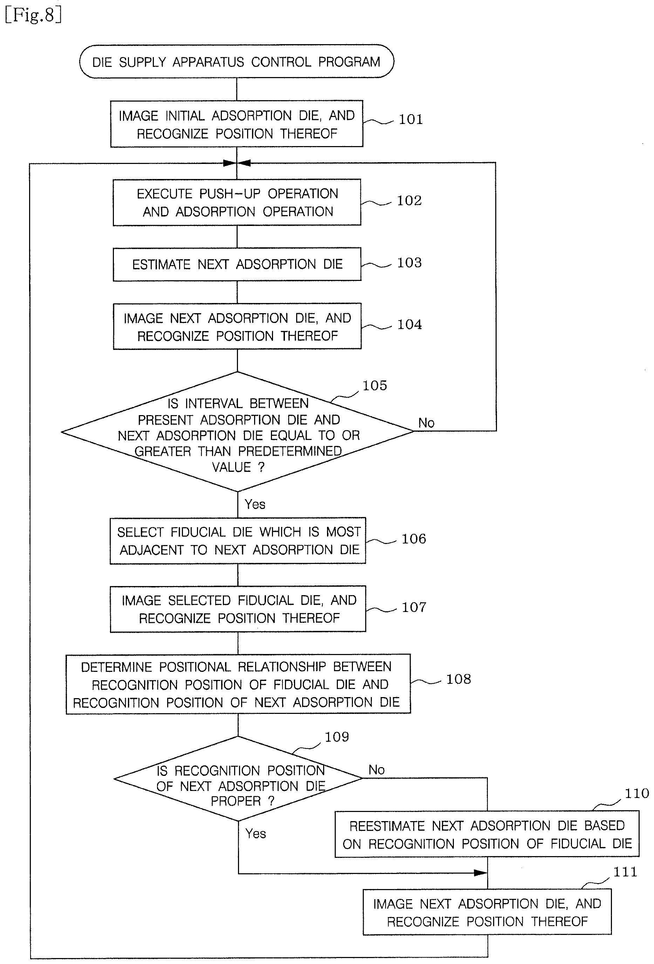

The above-described controlling of the die supply apparatus 11 in the present exemplary example is executed by the control device (the control means) of the die supply apparatus 11 in accordance with a die supply apparatus control program in Fig. 8. The control device of the die supply apparatus 11 is provided with a storage device (storage means) storing the wafer map data indicating the quality of the die 31 at each position on the dicing sheet 34, the position lacking the die 31, and the position of the fiducial die 45. The die supply apparatus control program in Fig. 8 is executed while the die supply apparatus 11 is in operation and also functions as the adsorption order decision means, the image processing means, and the next adsorption die position estimation means which are mentioned in Claims.

If the die supply apparatus control program in Fig. 8 is activated, firstly in Step 101, the initial adsorption die 31 is imaged by the camera 42, and an acquired image is processed, thereby recognizing the position of the die 31. Thereafter, the procedure proceeds to Step 102, and based on the recognition position of the die 31, the push-up position and the adsorption position of the die 31 are decided, thereby executing the push-up operation and adsorption operation of the die 31.

Thereafter, the procedure proceeds to Step 103, with reference to the wafer map data, based on the recognition position of the die 31 which is subjected to the present adsorption operation, and the position of the die 31 to be adsorbed next (the next adsorption die) is estimated. In this case, with reference to the wafer map data, the next non-defective position of the die is adopted as the next adsorption die 31(b) skipping the defective die A or the area lacking the die 31 from the present adsorption die 31(a). Thereafter, the procedure proceeds to Step 104, and the next adsorption die 31(b) is imaged by the camera 42 adopting the estimated position for the next adsorption die 31(b) as the target imaging position of the die, thereby recognizing the position for the next adsorption die 31(b).

Thereafter, the procedure proceeds to Step 105, and it is determined whether or not the interval between the present adsorption die 31(a) and the next adsorption die 31(b) is equal to or greater than a predetermined value. Here, "a predetermined value" may be set to the minimum value for the interval in which the position for the next adsorption die 31(b) may be mistakenly estimated due to the misalignment of the arrangement of the die 31. Moreover, the interval (the predetermined value) may be judged by the number of die arrangement pitches (the number of the defective dies A or the portions lacking the die 31 occurring within the interval), or may be judged by distance (mm). If the interval is judged by the number of the die arrangement pitches, the interval does not need to be converted into distance (mm), and thus, the calculation can be simplified to the extent thereof.

In Step 105 described above, if the interval between the present adsorption die 31(a) and the next adsorption die 31(b) is determined to be less than a predetermined value, it is judged that the estimated next adsorption die 31(b) is the proper next adsorption die 31(c), and the procedure returns to Step 102. Then, based on the recognition position of the die 31(b), the push-up position and the adsorption position of the die 31(b) are decided, and the push-up operation and adsorption operation of the die 31(b) are executed. Thereafter, the above-described processes from Steps 103 to 105 are repeated.

In contrast, in Step 105, if the interval between the present adsorption die 31(a) and the next adsorption die 31(b) is determined to be equal to or greater than a predetermined value, it is judged that the estimated next adsorption die 31(b) may not be the proper next adsorption die 31(c), and the procedure proceeds to Step 106. Then, with reference to the wafer map data, a fiducial die 45 which is most close to the recognition position of the estimated next adsorption die 31(b) is selected from the plurality of fiducial dies 45. Thereafter, the procedure proceeds to Step 107, and the selected fiducial die 45 is imaged by the camera 42, thereby recognizing the position of the fiducial die 45.

Thereafter, the procedure proceeds to Step 108, and the positional relationship between the recognition position of the fiducial die 45 and the recognition position for the next adsorption die 31(b) (a relative positional relationship between the former and the latter) is judged. Then in Step 109 following thereafter, based on the positional relationship between the recognition position of the fiducial die 45 and the recognition position for the next adsorption die 31(b), it is determined whether or not the recognition position for the next adsorption die 31(b) is the proper position for the next adsorption die 31(c). As a result, if it is determined that the recognition position for the next adsorption die 31(b) is not the proper position for the next adsorption die 31(c), the procedure proceeds to Step 110. Then, the position of the die 31(c) to be adsorbed next is reestimated based on the recognition position of the fiducial die 45, and the procedure proceeds to Step 111. The die 31(c) is imaged by the camera 42, the position of the die 31(c) is recognized, and the procedure returns to Step 102, thereby executing the push-up operation and adsorption operation.

Meanwhile, In Step 109, when it is determined that the recognition position for the next adsorption die 31(b) is the proper position for the next adsorption die 31(c) based on the positional relationship between the recognition position of the fiducial die 45 and the recognition position for the next adsorption die 31(b), the procedure proceeds to Step 111. Then, the die 31(c) is imaged by the camera 42, the position of the die 31(c) is recognized, and procedure returns to Step 102, thereby executing the push-up operation and adsorption operation. Then, by repeating the above-described processes, the dies 31 on the dicing sheet 34 are adsorbed in a predetermined order. Thereafter, in Step 103, if it is determined that there is no remaining next adsorption die 31, the program ends.

In Step 106, the fiducial die 45 which is most close to the recognition position of the estimated next adsorption die 31(b) is selected from the plurality of fiducial dies 45. However, the fiducial die 45 which is most close to the proper position for the next adsorption die 31(c) may be selected from the plurality of fiducial dies 45.

In the present exemplary example described above, when the interval from the position of the die 31(a) which is subjected to the present adsorption operation to the position for the next adsorption die 31(b) is equal to or greater than a predetermined value, the fiducial die 45 close to the next adsorption die 31(b) is imaged by the camera 42, and the position of the fiducial die 45 is recognized. Then, based on the positional relationship between the recognition position of the fiducial die 45 and the recognition position for the next adsorption die 31(b), it is determined whether or not the recognition position for the next adsorption die 31(b) is the proper position for the next adsorption die 31(c). Therefore, when the next adsorption die 31(b) estimated based on the position of the die 31(a) which is subjected to the present adsorption operation is the die at the position misaligned from the proper position for the next adsorption die 31(c), it is possible to reestimate the position of the die 31(c) to be adsorbed next based on the position of the fiducial die 45 close to the next adsorption die 31(b). Accordingly, even though the arrangement of the die 31 is in a misaligned state due to the unevenly expanded dicing sheet 34, the non-defective die can be adsorbed in proper adsorption order, and thus, it is possible to solve the disadvantage of mistakenly estimating and imaging the defective die A or the area lacking the die for the next adsorption die.

In the die supply apparatus 11 of the present exemplary example, the adsorption head 41 and the camera 42 are configured to integrally move in the XY-directions by the XY moving mechanism 25. However, the adsorption head 41 and the camera 42 may move in only the X-direction, and the position of the die 31 which is the imaging target and the adsorption target may be caused to move in the XY-directions by moving the wafer pallet 32 in a Y-direction above the pallet drawing-out table 23.

Moreover, it is needless to mention that the present invention may be executed by making various changes such as by suitably changing the configuration of the die supply apparatus 11 or the configuration of the wafer pallet 32, without departing from the scope of the gist thereof.

### Reference Signs List

11 ... die supply apparatus, 22 ... magazine holding section, 23 ... pallet drawing-out table, 25 ... XY moving mechanism, 28 ... push-up unit, 30 ... wafer expander, 31 ... die, 31(a) ... present adsorption die, 31(b) ... estimated next adsorption die, 31(c) ... proper next adsorption die, 32 ... wafer pallet, 33 ... dicing frame, 34 ... dicing sheet, 37 ... push-up pot, 39 ... push-up pin, 41 ... adsorption head, 42 ... camera, 43 ... suction nozzle, 45 ... fiducial die

## Claims

1. A die supply apparatus (11) including a wafer expander (30) in which an elastic dicing sheet (34) attached with a wafer that is diced so as to be divided into a plurality of dies (31) is expanded and a push-up mechanism (28) in which a push-up pin (39) that is disposed below the dicing sheet (34) moves vertically; pushing up an attachment portion of a target adsorption die on the dicing sheet (34) with the push-up pin (39), causing a suction nozzle (43) to adsorb a die (31), and picking the die (31) up from the dicing sheet (34), when the suction nozzle (43) is lowered and the die (31) on the dicing sheet (34) is adsorbed so as to be picked up, the apparatus comprising:
adsorption order decision means configured for deciding an adsorption order of the dies (31) on the dicing sheet (34);
a camera that images the dies (31) on the dicing sheet (34);
image processing means configured for recognizing a position of the die (31) by processing an image of the die (31) which is imaged by the camera;
next adsorption die position estimation means configured for estimating a position of a die (31(b), 31(c)) to be adsorbed next (hereinafter, referred to as "the next adsorption die") based on the recognition position of the die (31(a)) which is recognized by the image processing means;
control means configured for executing push-up operation and adsorption operation of the die (31) by causing the position for the next adsorption die (31(b), 31(c)) which is estimated by the next adsorption die position estimation means to be a target imaging position of the die (31) for every adsorption operation, imaging the next adsorption die (31(b), 31(c)) by the camera, and recognizing the position for the next adsorption die (31(b), 31(c)) by the image processing means; and
a plurality of image-recognizable fiducial dies (45) that are provided in a predetermined disposition in an arrangement of the dies (31) on the dicing sheet (34),
wherein when an interval from a position of the die (31(a)) which is subjected to a present adsorption operation to a position for the next adsorption die (31(b), 31(c)) estimated by the next adsorption die position estimation means is equal to or greater than a predetermined value, in addition to being configured for recognizing the position for the next adsorption die (31(b), 31(c)), the control means is also configured for selecting a fiducial die (45) close to the next adsorption die (31(b), 31(c)) from the plurality of fiducial dies (45), imaging the fiducial die (45) by the camera, recognizing the position of the fiducial die (45), and determining whether or not the recognition position for the next adsorption die (31(b), 31(c)) is the proper position for the next adsorption die (31(c)) based on a positional relationship between the recognition position of the fiducial die (45) and the recognition position for the next adsorption die (31(b), 31(c)); when it is determined that the recognition position for the next adsorption die (31(b), 31(c)) is the proper position for the next adsorption die (31(c)), the control means is also configured for executing push-up operation and adsorption operation based on the recognition position for the next adsorption die (31(c)); and when it is determined that the recognition position for the next adsorption die (31(b), 31(c)) is not the proper position for the next adsorption die (31(c)), the control means is also configured for reestimating a position of the die (31(b), 31(c)) to be adsorbed next based on the recognition position of the fiducial die (45), imaging the die (31(c)) by the camera, recognizing the position of the die (31(c)), and executing push-up operation and adsorption operation.

2. The die supply apparatus (11) according to Claim 1, further comprising:
storage means configured for storing wafer map data indicating quality of the die (31) at each position on the dicing sheet (34) and the position of the fiducial die (45),
wherein the next adsorption die position estimation means is configured for revising a position of a non-defective die to be adsorbed next based on the recognition position of the die which is recognized by the image processing means with reference to the wafer map data, and seeking the position for the next adsorption die, and
wherein when the interval from the position of the die (31(a)) which is subjected to the present adsorption operation to the position for the next adsorption die (31(b), 31(c)) estimated by the next adsorption die position estimation means is equal to or greater than a predetermined value, the control means is configured for selecting the fiducial die (45) close to the next adsorption die (31(b), 31(c)) from the plurality of fiducial dies (45) with reference to the wafer map data.

3. The die supply apparatus (11) according to Claim 1 or 2,
wherein the control means is configured for adopting the number of die arrangement pitches to judge the interval from the position of the die (31(a)) which is subjected to the present adsorption operation to the position for the next adsorption die (31(b), 31(c)) estimated by the next adsorption die position estimation means.

## Patentansprüche

1. Die-Zuführvorrichtung (11), die einen Wafer-Expander (30), in dem ein elastisches Dicing-Sheet (34) mit einem daran angebrachten Wafer, der gewürfelt wird, um in eine Vielzahl von Dies (31) geteilt zu werden, expandiert wird, und einen Hochdrückmechanismus (28), in dem sich ein unter dem Dicing-Sheet (34) angeordneter Hochdrückstift (39) vertikal bewegt, umfasst, einen Befestigungsteil eines Ziel-Adsorption-Dies an dem Dicing-Sheet (34) mit dem Hochdrückstift (39) hochdrückt, eine Saugdüse (43) zum Adsorbieren eines Dies (31) veranlasst und das Die (31) von dem Dicing-Sheet (34) aufgreift, wenn die Saugdüse (43) gesenkt wird und das Die (31) auf dem Dicing-Sheet (34) für das Aufgreifen adsorbiert wird, wobei die Vorrichtung umfasst:
eine Adsorptionsreihenfolge-Entscheidungseinrichtung, die konfiguriert ist zum Entscheiden einer Adsorptionsreihenfolge der Dies (31) auf dem Dicing-Sheet (34),
eine Kamera, die Bilder der Dies (31) auf dem Dicing-Sheet (34) aufnimmt,
eine Bildverarbeitungseinrichtung, die konfiguriert ist zum Erkennen der Position des Dies (31) durch das Verarbeiten eines durch die Kamera aufgenommenen Bilds des Dies (31),
eine Nächste-Adsorption-Die-Positionsschätzungseinrichtung, die konfiguriert ist zum Schätzen der Position eines als nächstes zu adsorbierenden Dies (31(b), 31(c)) (nachfolgend als "Nächste-Adsorption-Die" bezeichnet) basierend auf der durch die Bildverarbeitungseinrichtung erkannten Position des Dies (31(a)),
eine Steuereinrichtung, die konfiguriert ist zum Ausführen einer Hochdrückoperation und einer Adsorptionsoperation des Dies (31) durch das Verwenden der durch die Nächste-Adsorption-Die-Positionsschätzungseinrichtung geschätzten Position für das Nächste-Adsorption-Die als einer Zielabbildungsposition des Dies (31) für jede Adsorptionsoperation, das Abbilden des Nächste-Adsorption-Dies (31(b), 31(c)) durch die Kamera und das Erkennen der Position für das Nächste-Adsorption-Die (31(b), 31(c)) durch die Bildverarbeitungseinrichtung, und
eine Vielzahl von bilderkennbaren Fiducial-Dies (45), die an vorbestimmten Positionen in einer Anordnung der Dies (31) auf dem Dicing-Sheet (34) vorgesehen sind,
wobei, wenn die Distanz von einer Position des Dies (31(a)), das einer aktuellen Adsorptionsoperation unterworfen wird, zu einer durch die Nächste-Adsorption-Die-Positionsschätzungseinrichtung geschätzten Position für das Nächste-Adsorption-Die (31(b), 31 (c)) gleich oder größer als ein vorbestimmter Wert ist, die Steuereinrichtung zusätzlich dazu, dass sie konfiguriert ist zum Erkennen der Position für das Nächste-Adsorption-Die (31(b), 31(c)), weiterhin konfiguriert ist zum Auswählen eines Fiducial-Dies (45) nahe zu dem Nächste-Adsorption-Die (31(b), 31 (c)) aus der Vielzahl von Fiducial-Dies (45), zum Abbilden des Fiducial-Dies (45) durch die Kamera, zum Erkennen der Position des Fiducial-Dies (45) und zum Bestimmen, ob die erkannte Position für das Nächste-Adsorption-Die (31(b), 31 (c)) die korrekte Position für das Nächste-Adsorption-Die (31(c)) ist oder nicht, basierend auf der Positionsbeziehung zwischen der erkannten Position des Fiducial-Dies (45) und der erkannten Position für das Nächste-Adsorption-Die (31(b), 31(c)), wobei, wenn bestimmt wird, dass die erkannte Position für das Nächste-Adsorption-Die (31(b), 31(c)) die korrekte Position für das Nächste-Adsorption-Die (31(c)) ist, die Steuereinrichtung weiterhin konfiguriert ist zum Ausführen einer Hochdrückoperation und einer Adsorptionsoperation basierend auf der erkannten Position für das Nächste-Adsorption-Die (31(c)), und wenn bestimmt wird, dass die erkannte Position für das Nächste-Adsorption-Die (31(b), 31(c)) nicht die korrekte Position für das Nächste-Adsorption-Die (31(c)) ist, die Steuereinrichtung weiterhin konfiguriert ist zum erneuten Schätzen der Position des als nächstes zu absorbierenden Dies (31(b), 31(c) basierend auf der erkannten Position des Fiducial-Dies (45), zum Abbilden des Dies (31(c) durch die Kamera, zum Erkennen der Position des Dies (31(c)) und zum Ausführen einer Hochdrückoperation und einer Adsorptionsoperation.

2. Die-Zuführvorrichtung (11) nach Anspruch 1, die weiterhin umfasst:
eine Speichereinrichtung, die konfiguriert ist zum Speichern von Wafer-Mapdaten, die die Qualität des Dies (31) an jeder Position auf dem Dicing-Sheet (34) und die Position des Fiducial-Dies (45) angeben,
wobei die Nächste-Adsorption-Die-Positionsschätzungseinrichtung konfiguriert ist zum Ändern der Position eines nicht-defektiven und als nächstes zu absorbierenden Dies basierend auf der durch die Bildverarbeitungseinrichtung erkannten Position des Dies unter Bezugnahme auf die Wafer-Mapdaten und zum Suchen der Position für das Nächste-Adsorption-Die, und
wobei, wenn die Distanz von der Position des Dies (31(a)), das der aktuellen Adsorptionsoperation unterworfen wird, zu der durch die Nächste-Adsorption-Die-Positionsschätzungseinrichtung geschätzten Position für das Nächste-Adsorption-Die (31(b), 31(c)) gleich oder größer als ein vorbestimmter Wert ist, die Steuereinrichtung konfiguriert ist zum Auswählen des Fiducial-Dies (45) nahe dem Nächste-Adsorption-Die (31(b), 31(c)) aus der Vielzahl von Fiducial-Dies (45) unter Bezugnahme auf die Wafer-Mapdaten.

3. Die-Zuführvorrichtung (11) nach Anspruch 1 oder 2, wobei die Steuereinrichtung konfiguriert ist zum Verwenden der Anzahl von Anordnungsabständen für das Bestimmen der Distanz von der Position des der aktuellen Adsorptionsoperation unterworfenen Dies (31(a)) zu der durch die Nächste-Adsorption-Die-Positionsschätzungseinrichtung geschätzten Position für das Nächste-Adsorption-Die (31(b), 31(c)).

## Revendications

1. Appareil d'alimentation de matrice (11) comprenant un extenseur de tranche (30) dans lequel est étendue une feuille de découpage élastique (34) attachée à une tranche qui est découpée de manière à être divisée en une pluralité de matrices (31), et un mécanisme de relevage (28) dans lequel une broche de relevage (39) disposée sous la feuille de découpage (34) se déplace verticalement, relevant une portion de fixation d'une matrice d'adsorption cible sur la feuille de découpage (34) avec la broche de relevage (39), ce qui provoque l'adsorption d'une matrice (31) par une buse de succion (43) et le prélèvement de la matrice (31) sur la feuille de découpage (34), quand la buse de succion (43) est abaissée et la matrice (31) présente sur la feuille de découpage (34) est adsorbée de manière à être prélevée, l'appareil comprenant :
un moyen de décision d'ordre d'adsorption configuré pour décider d'un ordre d'adsorption des matrices (31) sur la feuille de découpage (34) ;
une caméra qui filme les matrices (31) sur la feuille de découpage (34) ;
un moyen de traitement d'images configuré pour reconnaître une position de la matrice (31) en traitant une image de la matrice (31) qui est filmée par la caméra ;
un moyen d'estimation de position de la prochaine matrice d'adsorption configuré pour estimer la position d'une matrice (31(b), 31(c)) à adsorber ensuite (désignée ci-après comme « la prochaine matrice d'adsorption ») sur base de la position de reconnaissance de la matrice (31 (a)) qui est reconnue par le moyen de traitement d'images ;
un moyen de contrôle configuré pour exécuter une opération de relevage et une opération d'adsorption de la matrice (31) en commandant que la position pour la prochaine matrice d'adsorption (31(b), 31(c)) estimée par le moyen d'estimation de position de la prochaine matrice d'adsorption soit une position d'imagerie cible de la matrice (31) pour chaque opération d'adsorption, pour filmer la prochaine matrice d'adsorption (31(b), 31(c)) à l'aide de la caméra, et pour reconnaître la position pour la prochaine matrice d'adsorption (31(b), 31(c)) à l'aide du moyen de traitement d'images ; et
une pluralité de matrices de référence reconnaissables sur image (45) qui sont pourvues à une position prédéterminée dans un agencement des matrices (31) sur la feuille de découpage (34),
dans lequel, quand un intervalle depuis une position de la matrice (31(a)) qui est soumise à une opération d'adsorption actuelle jusqu'à une position pour la prochaine matrice d'adsorption (31(b), 31(c)) estimée par le moyen d'estimation de position de la prochaine matrice d'adsorption est supérieur ou égal à une valeur prédéterminée, outre le fait qu'il est configuré pour reconnaître la position pour la prochaine matrice d'adsorption (31(b), 31(c)), le moyen de contrôle est configuré aussi pour sélectionner une matrice de référence (45) proche de la prochaine matrice d'adsorption (31(b), 31(c)) parmi la pluralité de matrices de référence (45), pour filmer la matrice de référence (45) à l'aide de la caméra, pour reconnaître la position de la matrice de référence (45), et pour déterminer si la position de reconnaissance pour la prochaine matrice d'adsorption (31(b), 31(c)) est ou non la position correcte pour la prochaine matrice d'adsorption (31(c)) sur base d'une relation de position entre la position de reconnaissance de la matrice de référence (45) et la position de reconnaissance pour la prochaine matrice d'adsorption (31(b), 31(c)) ; quand il est déterminé que la position de reconnaissance pour la prochaine matrice d'adsorption (31(b), 31(c)) est la position correcte pour la prochaine matrice d'adsorption (31(c)), le moyen de contrôle est également configuré pour exécuter une opération de relevage et une opération d'adsorption sur base de la position de reconnaissance pour la prochaine matrice d'adsorption (31 (c)) ; et quand il est déterminé que la position de reconnaissance pour la prochaine matrice d'adsorption (31(b), 31(c)) n'est pas la position correcte pour la prochaine matrice d'adsorption (31(c)), le moyen de contrôle est également configuré pour réestimer la position de la matrice (31(b), 31(c)) à adsorber ensuite sur base de la position de reconnaissance de la matrice de référence (45), pour filmer la matrice (31(c)) à l'aide de la caméra, pour reconnaître la position de la matrice (31(c)), et pour exécuter une opération de relevage et une opération d'adsorption.

2. Appareil d'alimentation de matrice (11) selon la revendication 1, comprenant en outre :
un moyen de stockage configuré pour stocker des données de mappage de tranche indiquant la qualité of the matrice (31) à chaque position sur la feuille de découpage (34) et la position de la matrice de référence (45),
dans lequel le moyen d'estimation de position de la prochaine matrice d'adsorption est configuré pour réviser la position d'une matrice non défectueuse à adsorber ensuite sur base de la position de reconnaissance de la matrice qui est reconnue par le moyen de traitement d'images en utilisant les données de mappage de tranche comme référence, et pour chercher la position pour la prochaine matrice d'adsorption, et
dans lequel, quand l'intervalle depuis la position de la matrice (31(a)) qui est soumise à l'opération d'adsorption actuelle jusqu'à la position pour la prochaine matrice d'adsorption (31(b), 31(c)) estimée par le moyen d'estimation de position de la prochaine matrice d'adsorption est supérieur ou égal à une valeur prédéterminée, le moyen de contrôle est configuré pour sélectionner la matrice de référence (45) proche de la prochaine matrice d'adsorption (31(b), 31(c)) parmi la pluralité de matrices de référence (45) en utilisant les données de mappage de tranche comme référence.

3. Appareil d'alimentation de matrice (11) selon la revendication 1 ou 2,
dans lequel le moyen de contrôle est configuré pour adopter le nombre de pas d'agencement de matrice pour estimer l'intervalle depuis la position de la matrice (31(a)) qui est soumise à l'opération d'adsorption actuelle jusqu'à la position pour la prochaine matrice d'adsorption (31(b), 31(c)) estimée par le moyen d'estimation de position de la prochaine matrice d'adsorption.
